Europäisches Patentamt

European Patent Office

Office européen des brevets

(11) Publication number: **0 432 781 A2**

# EUROPEAN PATENT APPLICATION

(21) Application number: **90124131.5**

(22) Date of filing: **13.12.90**

(51) Int. Cl.5: **C30B 31/16**

(30) Priority: **14.12.89 JP 324491/89**

(43) Date of publication of application:
**19.06.91 Bulletin 91/25**

(84) Designated Contracting States:
**DE FR GB**

(71) Applicant: **Kabushiki Kaisha Toshiba**
**72, Horikawa-cho Saiwai-ku**
**Kawasaki-shi(JP)**

(72) Inventor: **Wakashima, Kiyoshi, Intellectual**
**Property Division**

Kabushiki Kaisha Toshiba, 1-1 Shibaura
1-chome
Minato-ku, Tokyo 105(JP)
Inventor: Furusato, Yasuhiro, Intellectual
Property Division
Kabushiki Kaisha Toshiba, 1-1 Shibaura
1-chome
Minato-ku, Tokyo 105(JP)

(74) Representative: **Lehn, Werner, Dipl.-Ing. et al**
**Hoffmann, Eitle & Partner Patentanwälte**
**Arabellastrasse 4**
**W-8000 München 81(DE)**

(54) Method and device for manufacturing a diffusion type semiconductor element.

(57) In a device for manufacturing a diffusion type semiconductor element, dummy wafers (7) each having a diameter larger than that of each of a plurality of semiconductor wafers (8) are arranged between the semiconductor wafers formed in an upright manner and inlet (11) through which a carrier gas is incorporated in a diffusion tube (1) for diffusing an impurity into a semiconductor substrate. The carrier gas, i.e., an inert gas is flowed into the diffusion tube at an average velocity which is relatively higher than in a conventional device.

FIG. 2

## METHOD AND DEVICE FOR MANUFACTURING A DIFFUSION TYPE SEMICONDUCTOR ELEMENT

The present invention relates to a method and a device for manufacturing a semiconductor element which is improved in dispersion of basic characteristics of a transistor such as current amplification factor $h_{FE}$.

An open tube diffusion process for liquid phase epitaxy has been used as one of methods of forming an emitter constituting a transistor in a separate semiconductor element and in an integrated circuit. In this process, about 50 semiconductor wafers are vertically arranged at regular intervals in a diffusion tube. Carrier gas such as $N_2$ gas is flowed into the diffusion tube and, at the same time, an diffusion source or impurity such as phosphorus oxychloride ($POCl_3$) is diffused thereinto. The diffusion source is thus diffused at a predetermined position on a wafer.

Recently, in separate semiconductor elements and integrated circuits, an improvement in dispersion of current amplification factor $h_{FE}$ has strongly been demanded. If a required dispersion of current amplification factor $h_{FE}$ is very small, the yield of transistors is decreased, which makes it impossible to supply a large number of finished semiconductor elements. The dispersion of the current amplification factor is caused by dispersion of concentration and depth (Xj) of, for example, an emitter diffusion layer formed on a silicon wafer. The concentration becomes lower and the depth (Xj) becomes smaller toward the center of the silicon wafer. The dispersion occurs because a liquid phase diffusion source does not sufficiently diffuse between silicon wafers arranged at narrow intervals.

It is therefore proposed that an interval between the silicon wafers is broaden, but actually impossible since the efficiency for impurity diffusion is reduced and the productivity of semiconductor elements is lowered.

It is accordingly an object of the present invention to provide a method and a device for manufacturing a diffusion type semiconductor element in which, when an diffusion source is diffused into semiconductor wafers, an interval between the wafers is narrowed to enhance the productivity of semiconductor elements, and the dispersion of the depth and impurity concentration of a diffusion layer such as an emitter region is decreased, resulting in reduction of dispersion of current amplification factor $h_{FE}$.

To attain the above object, there is provided a method for manufacturing a diffusion type semiconductor element, comprising the steps of: forming a plurality of semiconductor wafers in a diffusion tube; forming dummy wafers between an inlet of carrier gas of the diffusion tube and the semiconductor wafers, an area of an image of the dummy wafer projected onto a plane perpendicular to a direction in which the carrier gas is flowed into the inlet being larger than that of an image of each of the semiconductor wafers projected onto the plane; flowing the carrier gas into the diffusion tube at an average velocity not less than a predetermined value; and mixing an diffusion source into the carrier gas.

According to the present invention, the average velocity of a liquid phase diffusion source flowing near the wafers arranged in parallel to one another in the diffusion tube, is kept at 3.0 cm/s or more, and dummy wafers each having a larger diameter than that of each of the semiconductor wafers are formed between the inlet of the diffusion tube and semiconductor wafers. An emitter region is formed in this manner, and the dispersion of the impurity concentration thereof is decreased. More specifically, the variation of the impurity concentration in the conventional device is $\pm 5\%$, and it is decreased down to $\pm 2\%$ by the present invention. Therefore, the dispersion of the characteristics peculiar to a transistor such as current amplification factor $h_{FE}$ is decreased.

This invention can be more fully understood from the following detailed description when taken in conjunction with the accompanying drawings, in which:

Fig. 1 is a schematic view showing a horizontal open type diffusion tube for liquid phase epitaxy according to an embodiment of the present invention;

Fig. 2 is an enlarged view of the diffusion tube shown in Fig. 1;

Fig. 3A is a view showing the characteristic of a semiconductor wafer manufactured using a conventional diffusion method;

Fig. 3B is a view showing the characteristic of a semiconductor wafer manufactured using a diffusion method according to the present invention; and

Fig. 4 is a schematic view showing a vertical open type diffusion tube for liquid phase epitaxy according to another embodiment of the present invention.

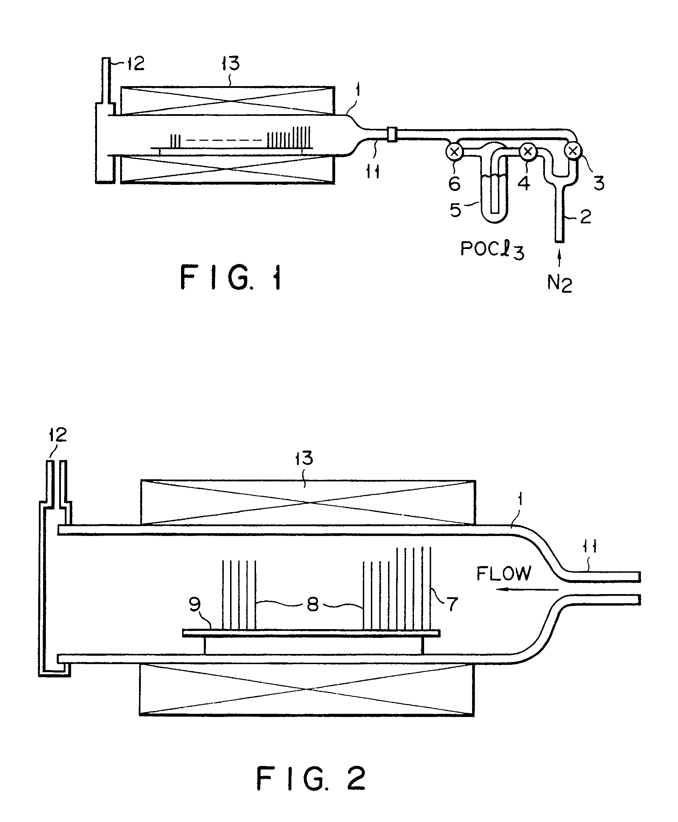

Embodiments of the present invention will be described with reference to the accompanying drawings. Fig. 1 illustrates a horizontal diffusion tube using an open tube diffusion process for liquid phase epitaxy. The present invention is not limited to the horizontal diffusion tube and can be applied to a horizontal diffusion tube using an open tube diffusion process for gas phase epitaxy and also to a vertical diffusion tube.

As is shown in Fig. 1, one end of diffusion tube 1 is narrowed to form inlet 11 for introducing carrier gas, and the other end thereof is closed and provided with outlet 12 for blowing up the carrier gas. Heater 13 is formed outside of diffusion tube 1, and connected to and controlled by a microcomputer (not shown) or the like to keep the inside of diffusion tube 1 at a predetermined temperature. Inert gas such as $N_2$ gas is introduced from a bomb (not shown) into diffusion tube 1 through line 2 and control valve 3. Control valve 3 includes a flowmeter and is connected to a microcomputer (not shown) or the like to control the flow rate of the carrier gas. Container 5 contains $POCl_3$, and $N_2$ is bubbled therein to generate an $N_2$ gas including $POCl_3$. The $N_2$ gas including $POCl_3$ is introduced into diffusion tube 1 together with the carrier gas.

Fig. 2 is an enlarged view of diffusion tube 1 shown in Fig. 1. Diffusion tube 1 is of a horizontal type, and its inner diameter is 185 mm and length is 2660 mm. Wafer boat 9 is arranged in the diffusion tube. Fifty silicon semiconductor wafers 8 each having a diameter of 5 inches are upright and parallel arranged at intervals of 6/16 inches on wafer boat 9. The position of wafer boat 9 at which wafers 8 are arranged is determined so as to assure the uniformity of the temperature around wafers 8 in diffusion tube 1.

Carrier gas such as $N_2$ gas is previously flowed into the diffusion tube at a prescribed flow rate of 50 L/min. The flow rate is converted into an average velocity of 3.1 cm/sec. The average velocity is much higher than a conventional average velocity of, for example, 1.9 cm/sec. To enhance the average velocity of the carrier gas as mentioned generates vortex or turbulent flow around semiconductor wafers 8 and causes carrier gas containing an diffusion source to flow between wafers 8. Diffusion source $POCl_3$ thus reaches the central portions of respective wafer 8 to prevent the impurity concentration therein from reducing.

Dummy wafers 7 each having a larger diameter than that of each of wafers 8 are arranged at the inlet side on wafer boat 9. In other words, an area of a dummy wafer image projected on a plane perpendicular to the direction (shown by arrow in Fig. 2) in which the carrier gas flows from inlet 11, is larger than that of a semiconductor wafer image projected on the plane. Dummy wafers 7 generate the turbulent flow of carrier gas $N_2$ containing impurity $POCl_3$ and further causes carrier gas $N_2$ to flow between the semiconductor wafers 8.

When wafers 8 are deposited in the diffusion tube, the temperature inside the diffusion tube ranges from 600 to 800° C. When the temperature gradually increases and reaches 1000 to 1100° C, a diffusion impurity such as phosphorus oxychloride ($POCl_3$) of a liquid phase is introduced by

means of $N_2$ gas. The supply of the phosphorus oxychloride and $N_2$ gas is stopped after a predetermined period of time. If the temperature inside the diffusion tube decreases to 600 to 800° C, wafer boat 9 is taken out of the tube, and the open tube diffusion process is completed.

In the above open tube diffusion process, a thermal oxide layer is formed on the surface of wafer 8 by an ordinary thermal oxidation process, and the oxide layer is opened at a position where an emitter region is to be formed by the photolithography process, then the open tube diffusion process is executed. A base region, which is essential to a transistor, is formed beforehand by the ion-implantation process, diffusion process or the like.

The interval between wafers is 6.16 inches in the above embodiment. However, the wafers can be arranged at a narrow interval of 3.16 inches.

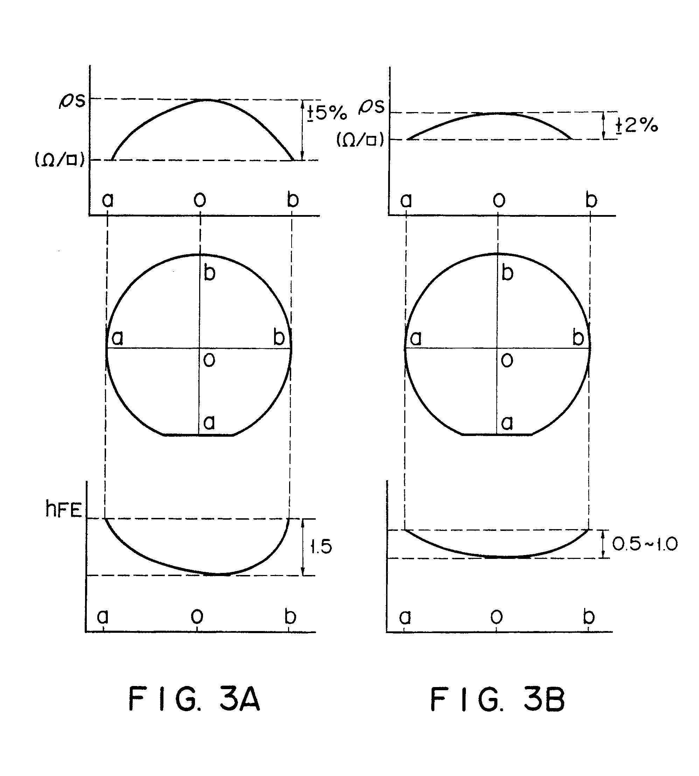

Figs. 3A and 3B show the characteristics of semiconductor wafers manufactured by the conventional method and the method according to the present invention, respectively. In these figures, the dispersion of sheet resistance $\rho s$ ($\Omega \square$) and of current amplification factor $h_{FE}$ are each compared between the conventional and present methods. Therefore, Figs. 3A and 3B show variations in the sheet resistance and current amplification factor from central portion 0 of wafer 8 to end portions a and b thereof. The variation in sheet resistance $\rho$ in the conventional method is +5% and that in the present invention is decreased to +2%. Current amplification factor $h_{FE}$ has a predetermined variation required by users (for example, a range between the current amplification factors which are 80 and 100 times). While the variation in the current amplification factor of the conventional method is about 1.5 times as large as the predetermined variation, that of the present invention is 0.5 to 1.0 times as large as the predetermined variation. In other words, the variation of the current amplification factor of the conventional method is reduced to 1.3 to 2.3 times as that of the present invention. It is evident from the comparison of the sheet resistance and that of the current amplification factor that the present invention is more advantageous. The reason why the variation in the sheet resistance and current amplification factor is reduced, is as follows. The increase in the velocity of carrier gas flowing through the diffusion tube generates the turbulent flow of carrier gas containing an impurity and promotes the impurity to flow between the wafers. Furthermore, since dummy wafer 7 having a larger diameter than that of semiconductor wafer 8 is arranged between inlet 11 of the diffusion tube and wafer 8, the turbulent flow is increasingly generated and a liquid-phase diffusion source is uniformly diffused into the wafers.

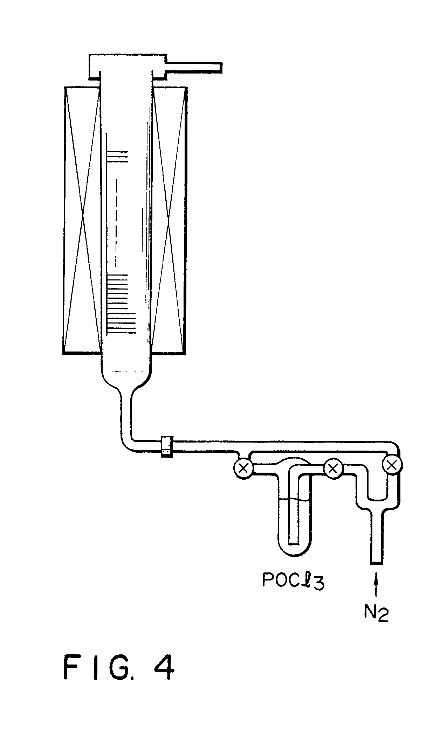

As has been described above, the present invention is applied to a horizontal diffusion tube using an open tube diffusion process. It is however apparent from Fig. 4, that it can be applied to a vertical diffusion tube using an open tube diffusion process.

Reference signs in the claims are intended for better understanding and shall not limit the scope.

## Claims

1. A method for manufacturing a diffusion type semiconductor element, characterized by comprising the steps of:

   arranging a plurality of semiconductor wafers (8) in a diffusion tube (1);

   placing dummy wafer (7) between an inlet (11) of carrier gas of said diffusion tube (1) and said semiconductor wafers (8), an area of an image of each of said dummy wafer projected onto a plane perpendicular to a direction in which the carrier gas is flowed into said inlet (11) being larger than that of an image of each of the semiconductor wafers projected onto the plane;

   flowing the carrier gas into said diffusion tube (1) at an average velocity not less than a predetermined value; and

   mixing an diffusion source into said carrier gas.

2. The method according to claim 1, characterized in that the predetermined value of said velocity is 3.0 cm/s.

3. The method according to claim 1, characterized in that said diffusion source is liquid.

4. The method according to claim 1, characterized in that said plurality of semiconductor wafers (8) are arranged on a wafer boat (9) including said dummy wafer (7).

5. The method according to claim 1, characterized in that said dummy wafer (7) and said semiconductor wafers (8) are substantially round, and a diameter of each of said dummy wafer (7) is larger than that of each of said semiconductor wafers (8).

6. A device for manufacturing a diffusion type semiconductor element, characterized by comprising:

   a diffusion tube (1), in which a plurality of semiconductor wafers (8) is arranged, for diffusing an diffusion source into said semiconductor wafers (8); an inlet (11) of said diffusion tube (1) into which a carrier gas for diffusing the diffusion source into the semiconductor wafers (8) is introduced;

   control means (3) for controlling a flow rate of the carrier gas to keep an average velocity of the carrier gas flowing through said semiconductor wafers (8) at not less than a predetermined value;

   mixing means (5) for mixing said diffusion source into said carrier gas; and

   dummy wafer means (7), formed between said inlet (11) and said semiconductor wafers (8), for generating a turbulent flow of said carrier gas, an area of an image of said dummy wafer means projected onto a plane perpendicular to a direction in which the carrier gas is flowed into said inlet (11) being larger than that of an image of each of the semiconductor wafers projected onto the plane.

7. The device according to claim 6, characterized in that said predetermined value of the average velocity of the carrier gas is 3.0 cm/s.

8. The device according to claim 6, characterized in that said dummy wafer means (7) and said semiconductor wafers (8) are substantially round, and said dummy wafer means (7) has a diameter larger than that of each of said semiconductor wafers (8).

9. The device according to claim 6, characterized in that said diffusion tube (1) includes a wafer boat (9) on which said semiconductor wafers (8) are arranged, and said wafer boat (9) includes said dummy wafer means (7).

10. The device according to claim 6, characterized in that said diffusion source is liquid.

F I G. 1

POC$l_3$

N$_2$

FLOW

F I G. 2

FIG. 3A

FIG. 3B

FIG. 4